# EUROPEAN PATENT APPLICATION

(11) **EP 4 230 400 A1**
(43) Date of publication of application: **23.08.2023**
(21) Application number: 21896575.4
(22) Date of filing: 11.10.2021
(51) Int. Cl.: B32B 17/06, B32B 7/12, B32B 33/00

(54) **COLOR PHOTOVOLTAIC MODULE HAVING IMPROVED EFFICIENCY AND PREPARATION METHOD THEREFOR**

(30) Priority: 25.11.2020 CN 202011339748
(71) Applicant: Colorful Lead Power (Beijing) Technology Co., Ltd., Beijing 101113 (CN)
(72) Inventor: XU, Jianzhi, Beijing 101113 (CN); ZHENG, Wenda, Beijing 101113 (CN)
(74) Representative: Jannig & Repkow Patentanwälte PartG mbB
(86) International application number: PCT/CN2021/122948
(87) International publication number: WO 2022/111073

(57) **Abstract**

The present invention provides a color photovoltaic module with improved efficiency, the color photovoltaic module successively comprising, from top to bottom, a color-bearing pattern, and a solar photovoltaic module, wherein the pattern comprises a printed white coating layer and a printed patterned color ink layer. By adjusting the level of the picture with the desired pattern, the printing software can control the amount of the white ink when the printer prints the white coating layer by recognizing different levels in the picture, and at the same time can control the printer such that there is no ink in the black and the white regions when the printer prints the color ink layer. By means of this method, not only the amount of the white ink used is reduced, the production cost of the color photovoltaic module is reduced, but also the shielding effect of the photovoltaic module is effectively reduced, the reflection of the white coating layer to the sunlight is reduced, the efficiency of the photovoltaic module and the security of the photovoltaic module are effectively improved, and the black color of the photovoltaic wafer itself is fully used, the three-dimensional sense of the pattern is effectively increased, and the gradation of the pattern is more obvious and enriched.

## Description

### FIELD OF TECHNOLOGY

The present invention is in the technical field of photovoltaic modules, in particular to a color photovoltaic module with improved efficiency and a method for preparing the same.

### BACKGROUND

As the concept of building photovoltaic integration has been more and more widely accepted in the field of photovoltaic, for photovoltaic products as building materials, it is desirable to choose individuals' own favorite colors to decorate their own buildings to highlight the personality of the buildings, which requires photovoltaic modules with various colors to meet the aesthetic requirements. There are generally two methods for forming an existing color photovoltaic module, one method is to directly print a white coating layer on a screen printer or a UV printer and then print a color ink layer on the white coating layer to form a color photovoltaic module; the other method is to print a color ink layer on the glass plate, then print a white coating layer on the color ink layer, and then encapsulate the glass plate and the photovoltaic module together by means of encapsulation to form a color photovoltaic module. Since the color of the photovoltaic wafer itself in the photovoltaic module is black or blue, if a white coating layer is not printed, the color of the color ink layer would be darker, less full and less brilliant, and printing the white coating layer can make the color ink layer fuller and make the color ink layer more brilliant. However, the white coating layer and the color ink layer have a strong shielding effect on solar light; the shielded photovoltaic wafer will be used as a load to consume the energy generated by other solar cell modules with illumination; the shielded photovoltaic wafer will generate heat at this time to exert a hot-spot effect which seriously reduces the energy efficiency of the photovoltaic wafer. Moreover, the titanium dioxide particles in the white coating layer also reflect light impinging on the solar photovoltaic module, reducing the energy efficiency of the solar photovoltaic module.

### SUMMARY

In order to solve the above technical problem, a first aspect of the present invention provides a color photovoltaic module with improved efficiency, which successively comprises, from top to bottom, a color-bearing pattern, and a solar photovoltaic module, wherein the pattern comprises at least a printed white coating layer and a printed patterned color ink layer.

Preferably, the pattern successively comprises, from top to bottom, a color ink layer and a white coating layer, and the solar photovoltaic module successively comprises, from top to bottom, a first glass layer, a first adhesive film layer, a photovoltaic wafer layer, a second adhesive film layer and a functional back plate layer.

Preferably, the pattern successively comprises, from top to bottom, a first glass layer, a color ink layer and a white coating layer, the solar photovoltaic module successively comprises, from top to bottom, a photovoltaic wafer layer, a second adhesive film layer and a functional back plate layer, and the pattern is bonded to the solar photovoltaic module via the first adhesive film layer.

Preferably, the pattern successively comprises, from top to bottom, a first glass layer, a color ink layer and a white coating layer, the solar module successively comprises, from top to bottom, a second glass layer, a second adhesive film layer, a photovoltaic wafer layer, a third adhesive film layer and a functional back plate layer, and the pattern is bonded to the solar photovoltaic module via the first adhesive film layer.

Preferably, the color ink layer has a thickness of 0 to 0.05 mm.

Preferably, the white coating layer has a thickness of 0 and 0.04 mm.

A second aspect of the present invention provides a preparation method for a color photovoltaic module with improved efficiency comprising at least the steps of: combining the pattern with a solar photovoltaic module.

Preferably, the specific method for printing the white coating layer and the color ink layer in the pattern comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the document 1 into a document 3 recognizable by the printing software, and controlling the printer by the printing software to perform printing to form a white coating layer; and
D: editing, by the printing software, the document 2 into a document 4 recognizable by the printing software, and controlling the printer by the printing software to perform printing to form a color ink layer.

Preferably, performing printing by a printer to form a white coating layer in the step C, the printer only produces white ink, and the printing software controls the amount of the white ink produced by the printer by recognizing a level in document 3, wherein the amount of the white ink produced with a level of 255 is 100%, the level decreases, and the amount decreases accordingly, the amount of the white ink with a level of 0 is 0%, and the amount per square meter of the white coating layer is 5-15 ml.

Preferably, performing printing by a printer to form a color ink layer in the step D, the printing software controls the amount of the color ink in the printer by recognizing the level in document 4, wherein no ink is produced with a level of 0, and no ink is produced with a level of 255, and there is 100% of the amount of ink produced for the remaining colors.

Advantageous effects: in this technical solution, by adjusting the level of the picture with the desired pattern, the printing software can control the amount of the white ink when the printer prints the white coating layer by recognizing different levels in the picture, and at the same time control that there is no ink in the black and the white regions when the printer prints the color ink layer. By means of this method, not only the amount of the white ink used is reduced, the production cost of the color photovoltaic module is reduced, but also the shielding effect of the photovoltaic module is effectively reduced, the reflection of the white coating layer to the sunlight is reduced, the transmittance of the solar rays is increased, the efficiency of the photovoltaic module and the security of the photovoltaic module are effectively improved, and the black color of the photovoltaic wafer itself is fully used, the three-dimensional sense of the pattern is effectively increased, and the gradation of the pattern is more obvious and enriched.

### BRIEF DESCRIPTION OF THE DRAWINGS

FIG. 1 is a schematic diagram showing the overall structure of a color photovoltaic module in Embodiment 1.
FIG. 2 is a schematic diagram showing the overall structure of a color photovoltaic module in Embodiment 2.
FIG. 3 is a schematic diagram showing the overall structure of a color photovoltaic module in Embodiment 3.
1- color ink layer, 2-white coating layer, 3-first glass layer, 4-first adhesive film layer, 5-photovoltaic wafer layer, 6-second adhesive film layer, 7-functional back plate layer, 8-second glass layer, 9-third adhesive film layer.

### DESCRIPTION OF THE EMBODIMENTS

For purposes of the following detailed description, it is to be understood that the invention may assume various alternative variations and step sequences, except where expressly specified to the contrary. Further, other than in any operating examples, or where otherwise indicated, all numbers expressing, for example, quantities of ingredients used in the description and claims are to be understood as being modified in all instances by the term "about". Accordingly, unless indicated to the contrary, the numerical parameters set forth in the following description and attached claims are approximations that may vary depending upon the desired properties sought to be obtained by the present invention. At the very least, and not as an attempt to limit the application of the doctrine of equivalents to the scope of the claims, each numerical parameter should at least be construed in light of the number of reported significant digits and by applying ordinary rounding techniques.

Notwithstanding that the numerical ranges and parameters setting forth the broad scope of the invention are approximations, the numerical values set forth in the specific examples are reported as precisely as possible. Any numerical value, however, inherently contains certain errors necessarily resulting from the standard deviation found in their respective testing measurements.

When a numerical range is disclosed herein, the foregoing range is considered to be continuous and includes the minimum and maximum values of the range, as well as every value between the minimum and maximum values. Further, when a range refers to an integer, every integer between the minimum and maximum values of the range is included. Further, when multiple ranges are provided to describe a feature or characteristic, the ranges can be combined. In other words, unless otherwise indicated, all ranges disclosed herein are to be understood to include any and all subranges subsumed therein. For example, a stated range of "1 to 10" should be considered to include any and all subranges between the minimum value of 1 and the maximum value of 10. Exemplary subranges of range 1 to 10 include, but are not limited to, 1-6.1, 3.5 to 7.8, 5.5 to 10, etc.

In order to solve the above technical problem, a first aspect of the present invention provides a color photovoltaic module with improved efficiency, which successively comprises, from top to bottom, a color-bearing pattern, and a solar photovoltaic module, wherein the pattern comprises at least a printed white coating layer and a printed patterned color ink layer.

As a preferred technical solution, the pattern successively comprises, from top to bottom, a color ink layer and a white coating layer, and the solar photovoltaic module successively comprises, from top to bottom, a first glass layer, a first adhesive film layer, a photovoltaic wafer layer, a second adhesive film layer and a functional back plate layer.

The functional back plate in the present invention comprises a plate layer having a supporting and protecting function such as a glass plate, a PE plate, a PC plate, a PET film, etc.

As a preferred technical solution, the pattern successively comprises, from top to bottom, a first glass layer, a color ink layer and a white coating layer, the solar photovoltaic module successively comprises, from top to bottom, a photovoltaic wafer layer, a second adhesive film layer and a functional back plate layer, and the pattern is bonded to the solar photovoltaic module via the first adhesive film layer.

As a preferred technical solution, the pattern successively comprises, from top to bottom, a first glass layer, a color ink layer and a white coating layer, the solar module successively comprises, from top to bottom, a second glass layer, a second adhesive film layer, a photovoltaic wafer layer, a third adhesive film layer and a functional back plate layer, and the pattern is bonded to the solar photovoltaic module via the first adhesive film layer.

As a preferred technical solution, the color ink layer has a thickness of 0-0.05 mm.

As a preferred technical solution, the color ink layer has a thickness of 0-0.0118mm.

As a preferred technical solution, the white coating layer has a thickness of 0-0.04 mm.

As a preferred technical solution, the white coating layer has a thickness of 0-0.02mm.

The inventors have found that the primary raw material in the white coating layer is titanium dioxide, which readily reflects off a portion of the sunlight transmitted to the white coating layer, reducing the transmission of sunlight to the solar cell sheets and reducing the efficiency of the photovoltaic module.

A second aspect of the present invention provides a preparation method for a color photovoltaic module with improved efficiency comprising at least the steps of: combining the pattern with a solar photovoltaic module.

As a preferred technical solution, the specific method for printing the white coating layer and the color ink layer in the pattern comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the document 1 into a document 3 recognizable by the printing software, and controlling the printer by the printing software to perform printing to form a white coating layer; and
D: editing, by the printing software, the document 2 into a document 4 recognizable by the printing software, and controlling the printer by the printing software to perform printing to form a color ink layer.

As a preferred technical solution, performing printing by a printer to form a white coating layer in the step C, the printer only produces white ink, and the printing software controls the amount of the white ink produced by the printer by recognizing a level in document 3, wherein the amount of the white ink produced with a level of 255 is 100%, the level decreases, and the amount decreases accordingly, the amount of the white ink with a level of 0 is 0%, and the amount per square meter of the white coating layer is 5-15 ml.

As a preferred technical solution, performing printing by a printer to form a color ink layer in the step D, the printing software controls the amount of the color ink in the printer by recognizing the level in document 4, wherein no ink is produced with a level of 0, and no ink is produced with a level of 255, and there is 100% of the amount of ink produced for the remaining colors.

During the experiments, the inventors found that controlling the amount of the white ink produced can not only reduce the reflection of sunlight by the white coating layer, improve the transmittance of sunlight, improve the overall efficiency of the photovoltaic module, but also reduce the production cost of the overall photovoltaic module. However, controlling the amount of the color ink produced does not significantly improve the efficiency of the photovoltaic module, the color saturation and brilliance of the pattern will decrease a lot, and the inventors mainly improve the energy efficiency of the photovoltaic module by adjusting the amount of the white ink produced.

In addition, if not stated otherwise, the starting materials used are commercially available.

### Embodiment 1

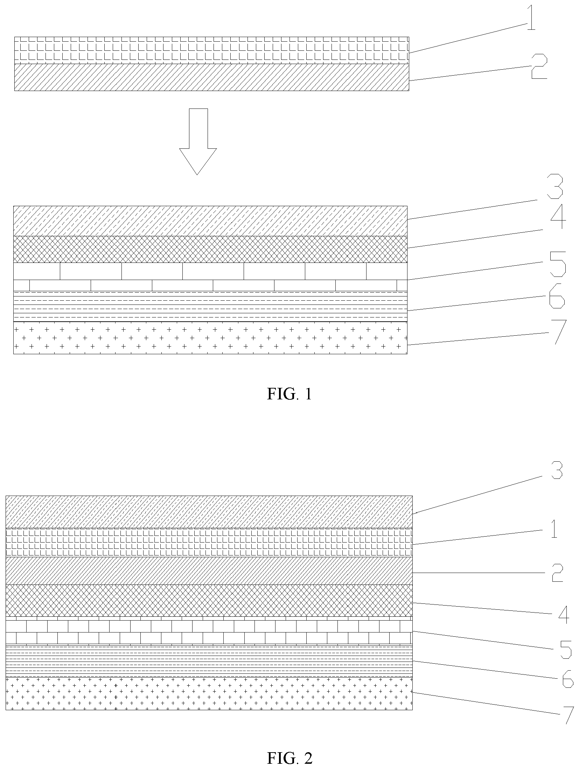

In order to solve the above-mentioned technical problem, a first aspect of this embodiment provides a color photovoltaic module with improved efficiency, as shown in FIG. 1, comprising a white coating layer 2 printed on a solar photovoltaic module, and a color ink layer 1 printed on the white coating layer 2, wherein the solar photovoltaic module successively comprises, from top to bottom, a first glass layer 3, a first adhesive film layer 4, a photovoltaic wafer layer 5, a second adhesive film layer 6 and a functional back plate layer 7, and the white coating layer 2 is directly printed on the first glass layer 3. In this embodiment, the white coating layer 2 and the color ink layer 1 are printed directly on the solar photovoltaic module.

The color ink layer 1 has a thickness of 0-0.0118 mm and the white coating layer 2 has a thickness of 0-0.02 mm.

A second aspect of this embodiment provides a method for preparing a color photovoltaic module with improved efficiency comprising the steps of:
(1) printing a white coating layer 2 on the first glass layer 3 of the solar photovoltaic module;
(2) printing a color ink layer 1 on the white coating layer 2.

The specific method for printing the white coating layer and the color ink layer comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the first document into a document 3 which can be recognized by the printing software; the printer only produces white ink, and the printing software controls the amount of the white ink produced by the printer by recognizing a level in document 3, wherein the amount of the white ink produced with a level of 255 is 100%, the level decreases, and the amount decreases accordingly, the amount of the white ink with a level of 0 is 0%, and the amount per square meter of the white coating layer is 5-15 ml; and printing same into a white coating layer by the printer; and
D: editing the document 2 into a document 4 recognizable by the printing software through the printing software; the printing software controls the amount of the color ink in the printer by recognizing the level in document 4, wherein no ink is produced with a level of 0, and no ink is produced with a level of 255, and there is 100% of the amount of ink produced for the remaining colors, which is printed into a color ink layer through the printer.

### Embodiment 2

In order to solve the above-mentioned technical problem, a first aspect of this embodiment provides a color photovoltaic module with improved efficiency, as shown in FIG. 2, which comprises a pattern and a solar photovoltaic module, wherein the pattern comprises a first glass layer 3, a color ink layer 1 printed on the first glass layer 3, and a white coating layer 2 printed on the color ink layer 1, and the solar photovoltaic module successively comprises, from top to bottom, a photovoltaic wafer layer 5, a second adhesive film layer 6 and a functional back plate layer 7, and the white coating layer 2 is bonded to the photovoltaic wafer layer 5 via the first adhesive film layer 4. In this embodiment, the color ink layer 1 and the white coating layer 2 are printed onto the first glass layer 3 and then encapsulated onto the solar photovoltaic module.

The color ink layer 1 has a thickness of 0-0.0118 mm and the white coating layer 2 has a thickness of 0-0.02 mm.

A second aspect of this embodiment provides a method for preparing a color photovoltaic module with improved efficiency comprising the steps of:
(1) printing a color ink layer 1 and a white coating layer on the first glass layer 3 to obtain a pattern; and
(2) binding the pattern to the solar photovoltaic module through the first adhesive film layer 4.

The specific method for printing the white coating layer and the color ink layer comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the first document into a document 3 which can be recognized by the printing software; the printer only produces white ink, and the printing software controls the amount of the white ink produced by the printer by recognizing a level in document 3, wherein the amount of the white ink produced with a level of 255 is 100%, the level decreases, and the amount decreases accordingly, the amount of the white ink with a level of 0 is 0%, and the amount per square meter of the white coating layer is 5-15 ml; and printing same into a white coating layer by the printer; and
D: editing the document 2 into a document 4 recognizable by the printing software through the printing software; the printing software controls the amount of the color ink in the printer by recognizing the level in document 4, wherein no ink is produced with a level of 0, and no ink is produced with a level of 255, and there is 100% of the amount of ink produced for the remaining colors, which is printed into a color ink layer through the printer.

### Embodiment 3

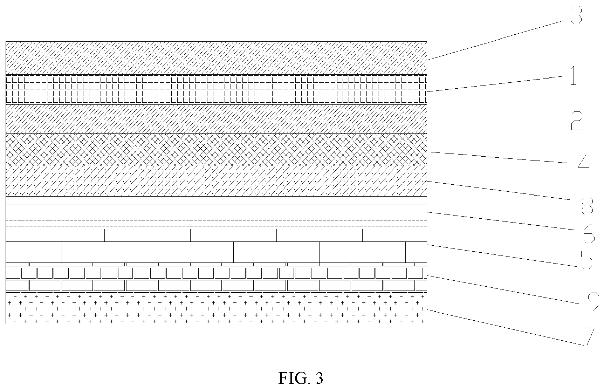

In order to solve the above-mentioned technical problem, a first aspect of this embodiment provides a color photovoltaic module with improved efficiency, as shown in FIG. 3, which comprises a pattern and a solar photovoltaic module, wherein the pattern comprises a first glass layer 3, a color ink layer 1 printed on the first glass layer 3, and a white coating layer 2 printed on the color ink layer 1, and the solar photovoltaic module successively comprises, from top to bottom, a second glass layer 8, a second adhesive film layer 6, a photovoltaic wafer layer 5, a third adhesive film layer 9 and a functional back plate layer 7, and the white coating layer 2 is bonded to the second glass layer 8 via the first adhesive film layer 4. In this embodiment, the color ink layer 1 and the white coating layer 2 are printed onto the first glass layer 3 and then encapsulated onto the solar photovoltaic module.

The color ink layer 1 has a thickness of 0-0.0118 mm and the white coating layer 2 has a thickness of 0-0.02 mm.

A second aspect of this embodiment provides a method for preparing a color photovoltaic module with improved efficiency comprising the steps of:
(1) printing a color ink layer 1 and a white coating layer on the first glass layer 3 to obtain a pattern; and
(2) binding the pattern to the solar photovoltaic module through the first adhesive film layer 4.

The specific method for printing the white coating layer and the color ink layer comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the first document into a document 3 which can be recognized by the printing software; the printer only produces white ink, and the printing software controls the amount of the white ink produced by the printer by recognizing a level in document 3, wherein the amount of the white ink produced with a level of 255 is 100%, the level decreases, and the amount decreases accordingly, the amount of the white ink with a level of 0 is 0%, and the amount per square meter of the white coating layer is 5-15 ml; and printing same into a white coating layer by the printer; and
D: editing the document 2 into a document 4 recognizable by the printing software through the printing software; the printing software controls the amount of the color ink in the printer by recognizing the level in document 4, wherein no ink is produced with a level of 0, and no ink is produced with a level of 255, and there is 100% of the amount of ink produced for the remaining colors, which is printed into a color ink layer through the printer.

### Comparative example 1

The difference between the Comparative example and Embodiment 2 lies in that the specific method for printing the white coating layer and the color ink layer in the Comparative example comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the first document into a document 3 which can be recognized by the printing software; the printer only produces white ink, and the printing software controls the amount of the white ink produced by the printer by recognizing a level in document 3, wherein the amount of the white ink produced with a level of 255 is 50%, the level decreases, and the amount decreases accordingly, the amount of the white ink with a level of 0 is 0%, and when there is 100% ink produced, the amount per square meter of the white coating layer is 5-15 ml; and printing same into a white coating layer by the printer; and
D: editing the document 2 into a document 4 recognizable by the printing software through the printing software; the printing software controls the amount of the color ink in the printer by recognizing the level in document 4, wherein no ink is produced with a level of 0, and no ink is produced with a level of 255, and there is 100% of the amount of ink produced for the remaining colors, which is printed into a color ink layer through the printer.

### Comparative example 2

The difference between the Comparative example and Embodiment 2 lies in that the specific method for printing the white coating layer and the color ink layer in the Comparative example comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the first document into a document 3 which can be recognized by the printing software; the printer only produces white ink, and the printing software controls the amount of the white ink produced by the printer by recognizing a level in document 3, wherein the amount of the white ink produced with a level of 255 is 20%, the level decreases, and the amount decreases accordingly, the amount of the white ink with a level of 0 is 0%, and when there is 100% ink produced, the amount per square meter of the white coating layer is 5-15 ml; and printing same into a white coating layer by the printer; and
D: editing the document 2 into a document 4 recognizable by the printing software through the printing software; the printing software controls the amount of the color ink in the printer by recognizing the level in document 4, wherein no ink is produced with a level of 0, and no ink is produced with a level of 255, and there is 100% of the amount of ink produced for the remaining colors, which is printed into a color ink layer through the printer.

### Comparative example 3

The difference between the Comparative example and Embodiment 2 lies in that the specific method for printing the white coating layer and the color ink layer in the Comparative example comprises:
A: editing a picture with a pattern by the printing software into a document recognizable by the printer, wherein the color is formed from 100% of the ink produced, and printing same into a color ink layer by the printer; and
B: performing printing by a printer to form a white coating layer on the color ink layer, wherein the amount per square meter of the white coating layer is 5-15 ml, 100% of the ink is produced, and the white coating layer is printed by the printer.

### Performance test

### Performance test I

According to the method for printing the white coating layer and the color ink layer in Embodiment 2, Comparative embodiment 1, Comparative embodiment 2 and Comparative embodiment 3, the white coating layer was first printed on the same transparent plastic sheet, then the color ink layer of the same pattern was printed on the white coating layer, and then the respective illuminance was measured under the same light intensity to characterize the light transmittance.

### Performance test II

Performance tests were conducted on the same area color photovoltaic modules made according to the methods of Embodiment 2, Comparative embodiment 1, Comparative embodiment 2, and Comparative embodiment 3 under the same conditions, and corresponding efficiency improvement rates were calculated based on the efficiency values of Comparative embodiment 3.

### Performance test III

20 volunteers were selected to observe and evaluate the distortion of the color patterns in Embodiment 2, Comparative embodiment 1, Comparative embodiment 2 and Comparative embodiment 3. It is evaluated to be excellent if the pattern color is full, it is evaluated to be good feedback if the pattern color has distortion, to be bad feedback if the pattern color has serious distortion, 0-1 bad feedbacks are considered to be excellent, 2-5 bad feedbacks are considered to be good, and more than 6 bad feedbacks are considered to be bad.

### Performance test table

| | Illumination (lux) | Potency (W) | Efficiency improvement (%) | Pattern color |
|---|---|---|---|---|
| Embodiment 2 | 158±3 | 1.2596 | 7.6 | Excellent |
| Comparative embodiment 1 (white ink 50%, color ink unchanged) | 170±3 | 1.2675 | 8.3 | Bad |
| Comparative embodiment 2 (white ink 20%, color ink unchanged) | 210±3 | 1.3221 | 12.9 | Bad |
| Comparative example 3 | 63±16 | 1.1707 | 0 | Excellent |

In this technical solution, by adjusting the level of the picture with the desired pattern, the printing software can control the amount of the white ink when the printer prints the white coating layer by recognizing different levels in the picture, and at the same time control that there is no ink in the black and the white regions when the printer prints the color ink layer. By means of this method, not only the amount of the white ink used is reduced, the production cost of the color photovoltaic module is reduced, but also the shielding effect of the photovoltaic module is effectively reduced, the reflection of the white coating layer to the sunlight is reduced, the transmittance of the solar rays is increased, the efficiency of the photovoltaic module and the security of the photovoltaic module are effectively improved, and the black color of the photovoltaic wafer itself is fully used, the three-dimensional sense of the pattern is effectively increased, and the gradation of the pattern is more obvious and enriched.

While the foregoing is directed to embodiments of the present invention, other and further embodiments of the invention may be devised without departing from the basic scope thereof, and the scope thereof is determined by the claims that follow. However, any simple modification, equivalent change and modification to the above embodiments according to the technical spirit of the present invention are still within the scope of the technical solution of the present invention, without departing from the contents of the technical solution of the present invention.

## Claims

1. A color photovoltaic module with improved efficiency, the color photovoltaic module successively comprising, from top to bottom, a color-bearing pattern, and a solar photovoltaic module, wherein the pattern comprises at least a printed white coating layer and a printed patterned color ink layer.

2. The color photovoltaic module with improved efficiency according to claim 1, wherein the pattern successively comprises, from top to bottom, a color ink layer and a white coating layer, and the solar photovoltaic module successively comprises, from top to bottom, a first glass layer, a first adhesive film layer, a photovoltaic wafer layer, a second adhesive film layer and a functional back plate layer.

3. The color photovoltaic module with improved efficiency according to claim 1, wherein the pattern successively comprises, from top to bottom, a first glass layer, a color ink layer and a white coating layer, the solar photovoltaic module successively comprises, from top to bottom, a photovoltaic wafer layer, a second adhesive film layer and a functional back plate layer, and the pattern is bonded to the solar photovoltaic module via the first adhesive film layer.

4. The color photovoltaic module with improved efficiency according to claim 1, wherein the pattern successively comprises, from top to bottom, a first glass layer, a color ink layer and a white coating layer, the solar module successively comprises, from top to bottom, a second glass layer, a second adhesive film layer, a photovoltaic wafer layer, a third adhesive film layer and a functional back plate layer, and the pattern is bonded to the solar photovoltaic module via the first adhesive film layer.

5. The color photovoltaic module with improved efficiency according to any one of claims 1-4, wherein the color ink layer has a thickness of 0 and 0.05 mm.

6. The color photovoltaic module with improved efficiency according to any one of claims 1-4, wherein the white coating layer has a thickness of 0-0.04 mm.

7. A method for preparing a color photovoltaic module with improved efficiency according to any one of claims 1-6, comprising at least the steps of: combining the pattern with a solar photovoltaic module.

8. The method for preparing a color photovoltaic module with improved efficiency according to claim 7, wherein the specific method for printing the white coating layer and the color ink layer in the pattern comprises:
A: processing a picture with a desired pattern by a picture processing software, adjusting the picture into a grey scale mode, and establishing a white spot color channel, and storing the picture as a document 1 recognizable by the printing software;
B: processing the picture with a desired pattern by a picture processing software, establishing a curve adjustment layer on the picture, and reducing the blackness value to the minimum, and storing the picture as a document 2 recognizable by the printing software;
C: editing, by the printing software, the document 1 into a document 3 recognizable by the printing software, and controlling the printer by the printing software to perform printing to form a white coating layer; and
D: editing, by the printing software, the document 2 into a document 4 recognizable by the printing software, and controlling the printer by the printing software to perform printing to form a color ink layer.

9. The method for preparing a color photovoltaic module with improved efficiency according to claim 8, wherein in step C, when performing printing by a printer to form a white coating layer in the step C, the printer only produces white ink, and the printing software controls the amount of the white ink produced by the printer by recognizing a level in document 3, the amount of the white ink produced with a level of 255 is 100%, the level decreases, and the amount decreases accordingly, the amount of the white ink with a level of 0 is 0%, and the amount per square meter of the white coating layer is 5-15 ml.

10. The method for preparing a color photovoltaic module with improved efficiency according to claim 9, wherein when performing printing by a printer to form a color ink layer in the step D, the printing software controls the amount of the color ink in the printer by recognizing the level in document 4, wherein no ink is produced with a level of 0, and no ink is produced with a level of 255, and there is 100% of the amount of ink produced for the remaining colors.
